# EUROPEAN PATENT APPLICATION

(11) **EP 4 760 376 A1**
(43) Date of publication of application: **17.06.2026**
(21) Application number: 24917343.6
(22) Date of filing: 30.12.2024
(51) Int. Cl.: G02F 1/01, G02F 1/00, G02F 1/139, G06F 3/01, F25D 29/00

(54) **REFRIGERATOR**

(30) Priority: 11.01.2024 KR 20240005073
(71) Applicant: Samsung Electronics Co., Ltd., Suwon-si, Gyeonggi-do 16677 (KR)
(72) Inventor: KIM, Youngno, Suwon-si Gyeonggi-do 16677 (KR); KIM, Minsoo, Suwon-si Gyeonggi-do 16677 (KR); SUH, Junwoo, Suwon-si Gyeonggi-do 16677 (KR); JUNG, Sungjin, Suwon-si Gyeonggi-do 16677 (KR)
(74) Representative: Gulde & Partner
(86) International application number: PCT/KR2024/021408
(87) International publication number: WO 2025/150749

(57) **Abstract**

Disclosed is a refrigerator including a storage compartment, a door configured provided on the storage compartment and configured to open and close, and a display provided on the door and including an electrocaloric material and a light-scattering material, wherein the display is configured to release heat from the storage compartment to the outside of the storage compartment upon determination that a voltage applied to the electrocaloric material and the light-scattering material is a first voltage less than a specified voltage and configured to reduce scattering of light incident on the display upon determination that a voltage applied to the electrocaloric material and the light-scattering material is a second voltage greater than the specified voltage.

## Description

### [Field]

The disclosure relates to a refrigerator including a display.

### [Description of Related Art]

A refrigerator is a home appliance including a main body having a storage compartment, a cooling air supply device provided to supply cooling air to the storage compartment, a door provided for opening and closing of the storage compartment, and used to store food in a fresh state.

In recent years, a display (or window) may be provided in doors of refrigerators to allow a user to check the status of the storage compartment, to run multiple applications, and to perform Internet of Things (IoT) functions without opening the door.

However, because heat is transferred into the storage compartment through the display provided in the door, energy efficiency of the refrigerator may decrease or it is difficult to control a haze (and/or transmittance) of the display.

### [Disclosure]

### [Technical Problem]

Embodiments of the disclosure provide a refrigerator including a display capable of cooling a storage compartment.

Embodiments of the disclosure provide a refrigerator including a display with an adjustable haze.

### [Technical Solution]

In accordance with an example embodiment of the disclosure, a refrigerator includes: a storage compartment, a door provided on the storage compartment and configured to open and close, and a display provided on the door and including an electrocaloric material and a light-scattering material, wherein the display is configured to: release heat to the outside of the storage compartment from the storage compartment by a change in the electrocaloric material based on application of a first voltage less than a specified voltage to the display, and reduce scattering of light incident on the display by a change in the light-scattering material based on application of a second voltage greater than the specified voltage to the display.

In accordance with an example embodiment of the disclosure, a refrigerator includes: a main body, a door pivotally coupled to the main body, and a window provided on the door and including a window including a first window layer and a second window layer farther from the inside of the main body than the first window layer, wherein the window is configured to: transfer heat inside the first window layer to the second window layer based on application of a voltage to the first window layer and removal of the voltage from the second window layer; and transfer heat inside the main body to the first window layer and heat inside the second window layer to the outside of the main body and the outside of the window based on removal of the voltage from the first window layer and application of the voltage to the second window layer.

In accordance with an example embodiment of the disclosure, a refrigerator includes: a main body, a door pivotally coupled to the main body, and a window provided on the door and including a light-scattering material, wherein the light-scattering material is aligned based on application of a voltage to the light-scattering material, and scattering of light incident on the window is reduced and a haze of the window is decreased.

### [BRIEF DESCRIPTION OF THE DRAWINGS]

The above and other aspects, features and advantages of certain embodiments of the present disclosure will be more apparent from the following detailed description, taken in conjunction with the accompanying drawings, in which:
FIG. 1 is a diagram illustrating a front view of a refrigerator according to various embodiments;
FIG. 2 is a perspective view of a refrigerator according to various embodiments;
FIG. 3 is a cross-sectional view of a display in a refrigerator according to various embodiments;
FIG. 4 is a diagram illustrating a display in a refrigerator according to various embodiments;
FIG 5 is a table illustrating operating voltage ranges of a display in a refrigerator according to various embodiments;
FIG. 6 is a sectional perspective view of a display in a refrigerator according to various embodiments;
FIG. 7 is a cross-sectional view of a display in a refrigerator according to various embodiments;
FIG. 8 is a cross-sectional view of a display in a refrigerator according to various embodiments;
FIG. 9 is a block diagram illustrating an example configuration of a refrigerator according to various embodiments;
FIG. 10 is a cross-sectional view of a display in a refrigerator according to various embodiments;
FIGS. 11A, 11B, 11C and 11D are diagrams illustrating a display in a refrigerator according to various embodiments; and
FIG. 12 is a graph regarding a display in a refrigerator according to various embodiments.

### [DETAILED DESCRIPTION]

The various example embodiments described in the disclosure and shown in the drawings are merely illustrative and are not intended to represent all aspects of the present disclosure, such that various equivalents and modifications may be made without departing from the spirit of the present disclosure.

In addition, like reference numerals denote like elements or components having substantially same functions in the drawings.

The terms used herein are merely used to describe various embodiments, and are not intended to limit the present disclosure. An expression used in the singular encompasses the expression of the plural, unless otherwise indicated. Throughout the disclosure, the terms such as "including" or "having" are intended to indicate the existence of features, numbers, processes, operations, components, parts, or combinations thereof disclosed herein, and are not intended to preclude the possibility that one or more other features, numbers, processes, operations, components, parts, or combinations thereof may exist or may be added.

In addition, as used herein, the expressions "A or B", "at least one of A and B", "at least one of A or B", "A, B or C", "at least one of A, B, and C", and "at least one of A, B, or C" may include only one of the listed items or any combination thereof.

In addition, the term "and/or" includes any and all combinations of one or more of the associated listed items.

In addition, it will be understood that, although the terms "first", "second", etc., may be used herein to describe various elements, these elements should not be limited by these terms. The above terms are used simply to distinguish one component from another. For example, a first component discussed below could be termed a second component, and similarly, the second component may be termed the first component without departing from the teachings of this disclosure. As used herein, the term "and/or" includes any combinations of one or more of the associated listed items.

In addition, as used herein, the term 'identical' refers to similar properties or similar within a certain range. The term identical may refer, for example, to 'substantially identical'. A value within a range of errors in manufacturing or a value corresponding to a difference within an insignificant range with respect to a standard value should be understood to fall in the range of substantially identical.

The terms "unit", "device", "block", "member", and "module" used herein refer to a unit used to process at least one function or operation. For example, these terms may refer to one or more hardware components such as field-programmable gate array (FPGA) or application specific integrated circuit (ASIC), or one or more software components or processors stored in a memory.

The terms used throughout the disclosure "front side", "rear side", "left side", "right side", and the like are defined based on the drawings and the shape and position of each element are not limited by these terms.

Hereinafter, various example embodiments of the present disclosure will be described in greater detail with reference to the accompanying drawings.

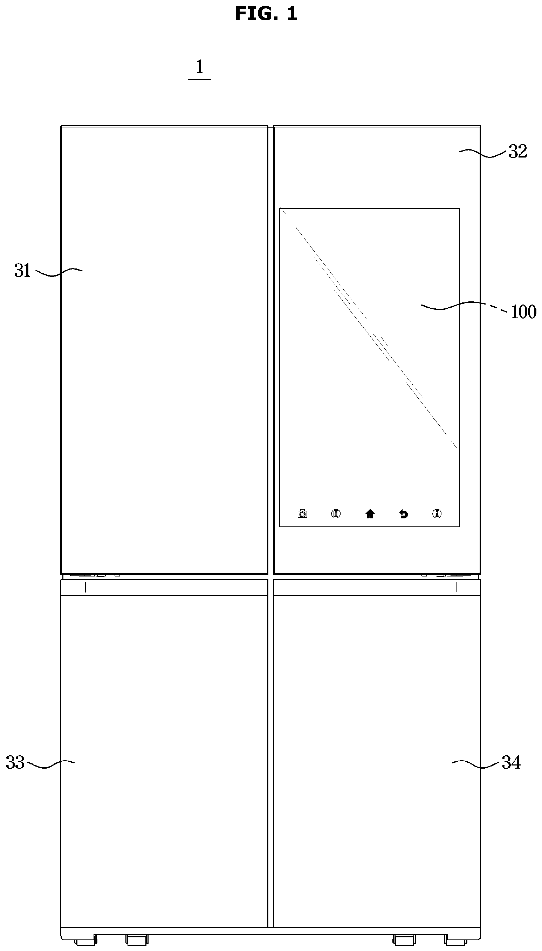

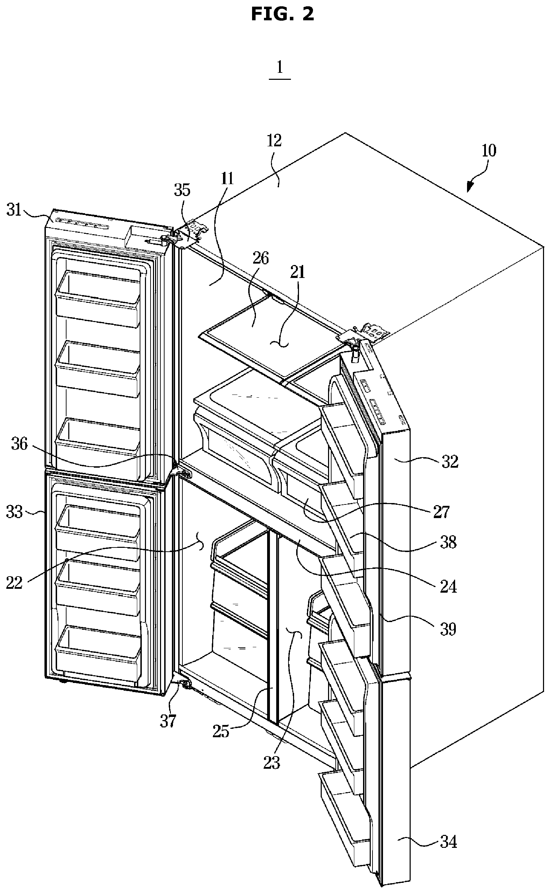

FIG. 1 is a diagram illustrating a front view of a refrigerator according to various embodiments. FIG. 2 is a perspective view of a refrigerator according to various embodiments.

Referring to FIGS. 1 and 2, a refrigerator 1 may include a main body 10, storage compartments 21, 22, and 23, formed in the main body 10, doors 31, 32, 33, and 34 for opening and closing of the storage compartments 21, 22, and 23, and a cooling air supply device configured to supply cooling air into the storage compartments 21, 22, and 23.

The main body 10 may include an inner cabinet 11 defining the storage compartments 21, 22, and 23, and outer cabinet 12 coupled to outer sides of the inner cabinet 11 and defining an external appearance, and an insulating material (not shown) disposed between the inner cabinet 11 and the outer cabinet 12 to insulate the storage compartments 21, 22, and 23.

The storage compartments 21, 22, and 23 may be divided into a plurality of storage compartments by a horizontal partition 24 and a vertical partition 25. The storage compartments 21, 22, and 23 may be divided into an upper storage compartment 21 and lower storage compartments 22 and 23 by the horizontal partition 24, and the lower storage compartments 22 and 23 may be divided into a left lower storage compartment 22 and a right lower storage compartment 23 by the vertical partition 25.

The upper storage compartment 21 may be used as a refrigerating compartment and the lower storage compartments 22 and 23 may be used as freezing compartments. However, the division and use of the storage compartments 21, 22, and 23 as described above are only an example and are not limited thereto.

Shelves 26 and storage containers 27 where food is placed may be provided in the storage compartments 21, 22, and 23.

The cooling air supply device may generate cooling air using a cooling circulation cycle of compressing, condensing, expanding, and evaporating a refrigerant and supply the generated cooling air to the storage compartments 21, 22, and 23.

The storage compartment 21 may be opened and closed by a pair of doors 31 and 32. The doors 31 and 32 may be pivotally coupled to the main body 10. The storage compartment 22 may be opened and closed by a door 33, and the door 33 may be pivotally coupled to the main body 10. The storage compartment 23 may be opened and closed by a door 34, and the door 34 may be pivotally coupled to the main body 10. The main body 10 may be provided with hinges 35, 36, and 37 to pivotally couple the doors 31, 32, 33, and 34 to the main body 10.

Door guards 38 may be mounted on the rear surface of the doors 31, 32, 33, and 34 to store food and a door gasket 39 may be provided in close contact with the front side of the main body 10 to seal the storage compartments 21, 22, and 23.

The refrigerator 1 may include a display 100. The display 100 may be provided on the doors 31, 32, 33, and 34. The display 100 may display various information related to a state and operation of the refrigerator or display various applications for the convenience of a user. The user may see the inside of the main body 10, e.g., the storage compartments 21, 22, and 23, from the outside of the main body 10 through the display 100. The display 100 may serve as a window 100 and/or an inspection window 100. Although the display 100 is provided on the door 32 in the embodiment, the display 100 may also be provided on other doors 31, 33, and 34.

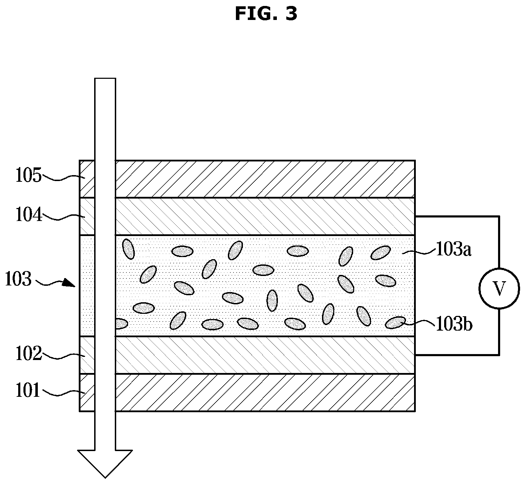

FIG. 3 is a cross-sectional view of a display in a refrigerator according to various embodiments.

Referring to FIG. 3, the refrigerator according to an embodiment may include the display 100. The display 100 may include an electrocaloric material 103a and a light-scattering material 103b. Both the electrocaloric material 103a and the light-scattering material 103b may be located in a changing layer 103. However, the electrocaloric material 103a and the light-scattering material 103b may be arranged in different layers.

The electrocaloric material 103a may include a material in which the electrocaloric effect occurs. The electrocaloric effect refers to a phenomenon in which an electric field (and/or voltage) applied to a certain dielectric material changes alignment of electric dipoles thereof, causing changes in entropy and temperature.

When an electric field (and/or voltage) is applied to the electrocaloric material 103a according to an embodiment, electric dipoles in the electrocaloric material 103a are aligned in the electric field direction, so that temperature of the electrocaloric material 103a may increase. As the temperature of the electrocaloric material 103a increases, the electrocaloric material 103a may release heat to the outside.

According to an embodiment, by removing the electric field therefrom after the electrocaloric material 103a releases heat, the alignment of electric dipoles in the electrocaloric material 103a disappears so that the temperature of the electrocaloric material 103a may decrease. As the temperature of the electrocaloric material 103a decreases, the electrocaloric material 103a may absorb heat from the outside.

Therefore, upon application of the electric field to the changing layer 103 in which the electrocaloric material 103a is located, the temperatures of the electrocaloric material 103a and the changing layer 103 increase, so that heat is released to the outside of the display 100 from the electrocaloric material 103a and the changing layer 103. Thereafter, when the electric field is removed from the changing layer 103 in which the electrocaloric material 103a is located, the temperatures of the electrocaloric material 103a and the changing layer 103 decrease, so that the electrocaloric material 103a and the changing layer 103 in which the electrocaloric material 103a is located may absorb heat from the outside of the display 100.

For example, in the case where the temperature of the display 100 and external air is 25°, the temperature of the display 100 may increase to a higher temperature (e.g., 26°) than 25° by applying an electric field to the changing layer 103 in which the electrocaloric material 103a is located. Thereafter, the display 100 may release heat to the outside of the main body 10 and/or the doors 31, 32, 33, and 34 and return to 25°. By removing the electric field from the changing layer 103 in which the electrocaloric material 103a is located, the temperature of the display 100 may decrease to a lower temperature (e.g. 24°) than 25°. Thereafter, the display 100 may absorb heat from the inside of the storage compartments 21, 22, and 23 and return to 25°.

In the refrigerator according to an embodiment, the display 100 may absorb heat from the inside of the storage compartments 21, 22, and 23 and release heat to the outside of the display 100 and the outside of the storage compartments 21, 22, and 23 by repeating applying and removing the electric field (and/or voltage) to and from the changing layer 103. The outside of the display 100 and the outside of the storage compartments 21, 22, and 23 may include the outside of the doors 31, 32, 33, and 34 and the main body 10. By applying the electric field to the electrocaloric material 103a, the display 100 releasing heat to the outside of the display 100 and the storage compartments 21, 22, and 23 may turn to a heat-releasing state. The heat-releasing state may include an opaque state. The opaque state may be expressed as a cloudy state, a non-transmittance state, a high absorption state, and/or a high refractive-index difference state. The heat-releasing state may also be expressed as a heat-releasing mode.

Therefore, the display 100 including the electrocaloric material 103a may improve the heat insulation effect of the storage compartments 21, 22, and 23 by minimizing and/or reducing heat transfer into the storage compartments 21, 22, and 23 through the display 100. In addition, the display 100 may cool the inside of the storage compartments 21, 22, and 23.

Although the electrocaloric material 103a is distributed throughout the changing layer 103 in the drawing, the arrangement of the electrocaloric material 103a is not limited thereto, and the electrocaloric material 103a may be densely arranged in one side of the changing layer 103.

The electrocaloric material 103a may be mixed with the light-scattering material 103b. The light-scattering material 103b may be provided in plural numbers. The light-scattering material 103b may include liquid crystals, polymer dispersed liquid crystals (PDLCs), electrochromic materials, and suspended particle devices. In addition, the light-scattering material 103b may include a light-absorbing material. A plurality of light-scattering materials 103b may be dispersed in the electrocaloric material 103a. light incident on the changing layer 103 may collide with the light-scattering material 103b to be scattered.

Based on application of the electric field to the light-scattering material 103b, the light-scattering material 103b may move and/or be changed. For example, by the electric field applied to the light-scattering material 103b, the light-scattering material 103b may be aligned in the electric field direction. As the light-scattering material 103b is aligned, a collision rate of light incident on the changing layer 103 with the light-scattering material 103b may be reduced, and light may pass through the changing layer 103 in a state where scattering of light tis reduce. As light scattering is reduced, the haze of the changing layer 103 and the display 100 may be reduced. With a lower haze of the display 100, a user may see the inside of the storage compartments 21, 22, and 23 through the display 100.

In the absence of the electric field applied to the light-scattering material 103b, the alignment of the light-scattering material 103b may disappear. When the alignment of the light-scattering material 103b disappears, the collision rate of the light incident on the changing layer 103 with the light-scattering material 103b may increase, and thus light may pass through the changing layer 103 in a state where light scattering is increased. As the light scattering increases, the haze of the changing layer 103 and the display 100 may increase.

The haze may be expressed as light absorptivity, refractive index, transmittance, and/or transparency. Therefore, by applying the electric field to the changing layer 103 and the display 100, the light absorptivity, refractive index, transmittance, and/or transparency of the changing layer 103 and display 100 may change.

For example, by applying the electric field to the changing layer 103 and the display 100 including the light-scattering material 103b, the light absorptivity of the changing layer 103 and the display 100 may decrease, differences in the refractive index with respect to an incidence direction of light between the light-scattering material 103b and other materials of the changing layer 103 may decrease, and transmittance and transparency thereof may increase. By removing the electric field from the changing layer 103 and the display 100 including the light-scattering material 103b, light absorptivity of the changing layer 103 and the display 100 may increase, differences in the refractive index with respect to an incidence direction of light between the light-scattering material 103b and other materials of the changing layer 103 may increase, and transmittance and transparency thereof may decrease.

However, by applying the electric field to the changing layer 103 and the display 100 including the light-scattering material 103b, the light absorptivity of the changing layer 103 and the display 100 may increase, differences in the refractive index with respect to an incidence direction of light between the light-scattering material 103b and other materials of the changing layer 103 may increase, and transmittance and transparency thereof may decrease. By removing the electric field from the changing layer 103 and the display 100 including the light-scattering material 103b, light absorptivity of the changing layer 103 and the display 100 may decrease, differences in the refractive index with respect to an incidence direction of light between the light-scattering material 103b and other materials of the changing layer 103 may decrease, and transmittance and transparency thereof may increase.

By applying the electric field to the light-scattering material 103b, the state of the display 100 with a reduced haze may turn to a transparent state. The transparent state may be expressed as a clear state, a high transmittance state, a low absorption state, and/or a small refractive-index difference state. The transparent state may also be expressed as a transparent mode.

The display 100 may include a plurality of thin films. The plurality of thin films may include transparent substrates 101 and 105 and transparent electrodes 102 and 104.

The display 100 may further include the transparent electrodes 102 and 104. The transparent electrodes 102 and 104 may allow currents to or not to flow in the changing layer 103 in which the electrocaloric material 103a and the light-scattering material 103b are located. For example, the transparent electrodes 102 and 104 may apply or remove the electric field to or from the changing layer 103.

The transparent electrodes 102 and 104 may include indium tin oxide (ITO), antimony tin oxide (ATO), poly(3,4-ethylenedioxythiophene):poly polystyrene sulfonate (PEDOT:PSS), carbon nano tube (CNT), graphene, and silver nanowire (AgNW).

The transparent electrodes 102 and 104 may be provided in plural numbers. The plurality of transparent electrodes 102 and 104 may include a first transparent electrode 102 and a second transparent electrode 104. The plurality of transparent electrodes 102 and 104 may be disposed on both sides of the changing layer 103. For example, the first transparent electrode 102 may be disposed on a first side of the changing layer 103. In addition, for example, the second transparent electrode 104 may be disposed on a second side of the changing layer 103 opposite to the first side of the changing layer 103.

The display 100 may further include the transparent substrates 101 and 105. The transparent substrates 101 and 105 may protect the changing layer 103 and/or the transparent electrodes 102 and 104 from damage to the changing layer 103 and/or the transparent electrodes 102 and 104. The transparent substrates 101 and 105 may include a transparent film and a transparent cover. The transparent substrates 101 and 105 may be provided in plural numbers.

The plurality of transparent substrates 101 and 105 may include the first transparent substrate 101 and the second transparent substrate 105. The first transparent substrate 101 may be disposed on one side of the first transparent electrode 102. For example, the first transparent substrate 101 may be disposed on a first side of the first transparent electrode 102 and the changing layer 103 may be disposed on a second side of the first transparent electrode 102. The first transparent electrode 102 may be in contact with the first transparent substrate 101.

The second transparent substrate 105 may be disposed on one side of the second transparent electrode 104. For example, the changing layer 103 may be disposed on a first side of the second transparent electrode 104, and the second transparent substrate 105 may be disposed on a second side of the second transparent electrode 104. The second transparent electrode 104 may be in contact with the second transparent substrate 105.

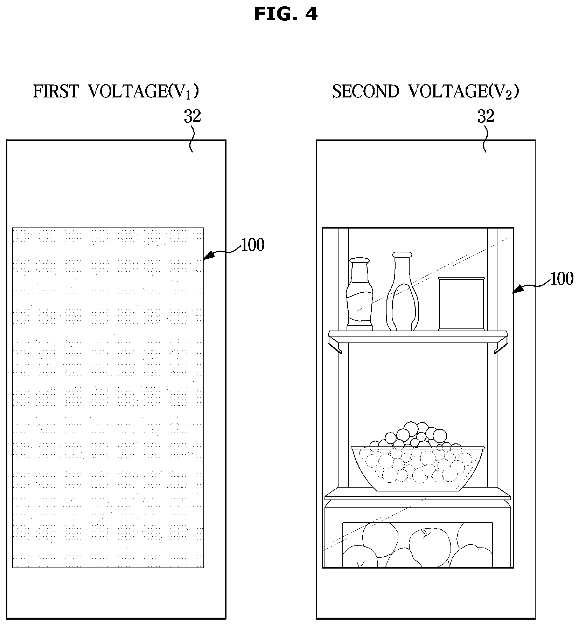

The user may see the inside of the storage compartments 21, 22, and 23 through the changing layer 103, the transparent electrodes 102 and 104, and the transparent substrates 101 and 105, which became transparent by applying the electric field thereto, without opening the doors 31, 32, 33, and 34. Therefore, the user convenience may be increased (Refer, e.g., to FIG. 4).

Although light travels from the second transparent substrate 105 to the first transparent substrate 101 through the changing layer 103 in the drawing, the optical path is not limited thereto.

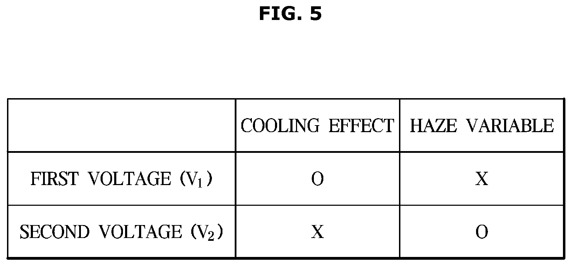

FIG. 4 is a diagram illustrating a display in a refrigerator according to various embodiments. FIG 5 is a table illustrating operating voltage ranges of a display of a refrigerator according to various embodiments.

Referring FIGS. 4 and 5, in the refrigerator according to an embodiment, a haze (e.g., opacity) of the display 100 may change according to a voltage (and/or electric field) applied to the changing layer 103. For example, as the voltage applied to the changing layer 103 increases, the haze of the display 100 may decrease.

The refrigerator according to an embodiment may prevent and/or reduce heat loss by transferring heat inside the storage compartments 21, 22, and 23 to the outside of the main body 10, the doors 31, 32, 33, and 34, and the storage compartments 21, 22, and 23 by the electrocaloric effect of the electrocaloric material 103a at a voltage lower than the preset (e.g., specified) voltage. In other words, the display 100 may minimize/reduce and/or prevent/reduce heat transfer from the outside of the main body 10, doors 31, 32, 33, and 34 and storage compartments 21, 22, and 23 into the storage compartments 21, 22, and 23 through the display 100 by the electrocaloric effect of the electrocaloric material 103a at a voltage lower than the preset voltage.

The voltage lower than the preset voltage applied to the display 100 may be a first voltage V1. For example, the preset voltage may be 40 V, and the first voltage V1 may equal to or lower than 40 V.

In the refrigerator according to an embodiment, the display 100 may absorb heat from the storage compartments 21, 22, and 23 and release heat to the outside of the storage compartments 21, 22, and 23 by repeatedly applying and removing the first voltage V1 to and from the changing layer 103.

In the refrigerator according to an embodiment, the haze of the changing layer 103 may decrease as light scattering by the light-scattering material 103b decreases at a voltage greater than a preset voltage. Due to the reduced haze of the changing layer 103, the user may see the inside of the storage compartments 21, 22, and 23 through the display 100, and thus the user convenience may be improved. The voltage greater than the preset voltage applied to the display 100 may be a second voltage V2. Therefore, the second voltage V2 may be greater than the first voltage V1. For example, the preset voltage may be 40 V, and the second voltage V2 may be a voltage equal to or greater than 40 V.

For example, based on application of the first voltage V1 to the display 100, the haze of the changing layer 103 and/or the display 100 may be 50 % or more. In addition, for example, based on application of the second voltage V2 to the display 100, the haze of the changing layer 103 and/or the display 100 may be 50 % or less. In addition, for example, a difference between the haze in the case of applying the first voltage V1 to the display 100 and that in the case of applying the second voltage V2 thereto may be 50 % or more.

For example, the display 100 may be opaque in the case of applying the first voltage V1, and the display 100 may be more transparent in the case of applying the second voltage V2 than at the first voltage V1. Therefore, the transparency of the display 100 may be adjusted by controlling the voltage applied to the display 100 in the refrigerator according to an embodiment.

The refrigerator according to an embodiment allows the user to see the inside of the storage compartments 21, 22, and 23 through the display 100 using the effect of aligning the light-scattering material 103b during application of the second voltage V2 to the display 100, while the display 100 performs insulation to prevent and/or reduce heat transfer into the storage compartments 21, 22, and 23 using the electrocaloric effect obtained by the electrocaloric material 103a during application of the first voltage V1 to the display 100.

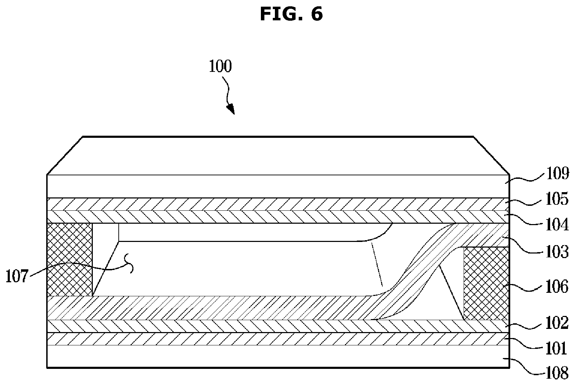

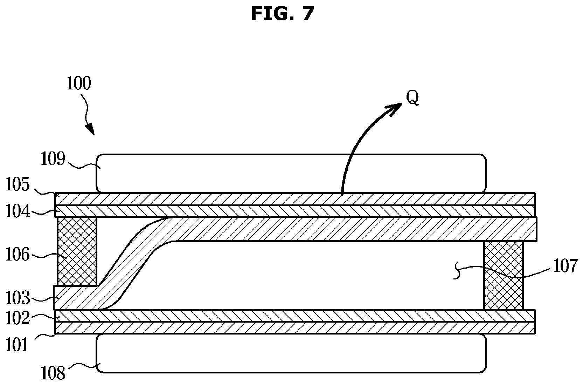

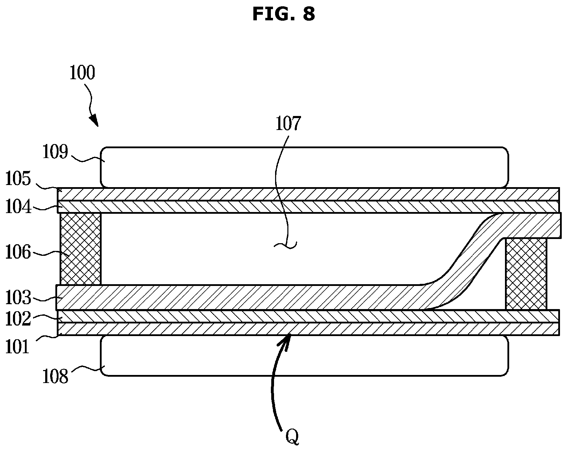

FIG. 6 is a perspective sectional view of a display in the refrigerator according to various embodiments. FIG. 7 is a cross-sectional view of a display in the refrigerator according to various embodiments. FIG. 8 is a cross-sectional view of a display in the refrigerator according to various embodiments.

Referring to FIG. 6, the display 100 may include a plurality of thin films. The plurality of thin films may include transparent substrates 101 and 105 and transparent electrodes 102 and 104.

The transparent electrodes 102 and 104 may be provided in plural numbers. The plurality of transparent electrodes 102 and 104 may include a first transparent electrode 102 and a second transparent electrode 104.

The first transparent electrode 102 may be closer to the storage compartment than the second transparent electrode 104. The first transparent electrode 102 may be disposed between the first transparent substrate 101 and the changing layer 103. The first transparent electrode 102 may be in contact with the first transparent substrate 101. A portion of the first transparent electrode 102 may be in contact with the changing layer 103. The first transparent electrode 102 may exchange heat with the changing layer 103. The second transparent electrode 104 may be farther from the storage compartment than the first transparent electrode 102. The second transparent electrode 104 may be disposed between the second transparent substrate 105 and the changing layer 103. The second transparent electrode 104 may be in contact with the second transparent substrate 105. A portion of the second transparent electrode 104 may be in contact with the changing layer 103. The second transparent electrode 104 may exchange heat with the changing layer 103.

The transparent substrates 101 and 105 may be provided in plural numbers. The plurality of transparent substrates 101 and 105 may include a first transparent substrate 101 and a second transparent substrate 105.

The first transparent substrate 101 may be closer to the storage compartments 21, 22, and 23 than the second transparent substrate 105. The first transparent substrate 101 may be disposed between the first transparent electrode 102 and a first heat transfer member 108. The first transparent substrate 101 may be in contact with the first transparent electrode 102 and the first heat transfer member 108. The first transparent substrate 101 may exchange heat with the first heat transfer member 108. The second transparent substrate 105 may be farther from the storage compartments 21, 22, and 23 than the first transparent substrate 101. The second transparent substrate 105 may be disposed between the second transparent electrode 104 and the second heat transfer member 109. The second transparent substrate 105 may be in contact with the second transparent electrode 104 and the second heat transfer member 109. The second transparent substrate 105 may exchange heat with the second heat transfer member 109.

The plurality of thin films may further include the heat transfer members 108 and 109. The heat transfer members 108 and 109 may be in contact with the transparent substrates 101 and 105 and exchange heat with the transparent substrates 101 and 105. The heat transfer members 108 and 109 may include a transparent film, a transparent substrate, and the like. The heat transfer members 108 and 109 may comprise a material with high thermal conductivity. For example, the heat transfer members 108 and 109 may include graphene.

The heat transfer members 108 and 109 may include a plurality of heat transfer members 108 and 109. The plurality of heat transfer members 108 and 109 may include a first heat transfer member 108 and a second heat transfer member 109.

The first heat transfer member 108 may be closer to the storage compartments 21, 22, and 23 than the second heat transfer member 109, the transparent electrodes 102 and 104, and the transparent substrates 101 and 105. The first heat transfer member 108 may be disposed between the first transparent substrate 101 and the storage compartments 21, 22, and 23. The first heat transfer member 108 may be in contact with the first transparent substrate 101. The first heat transfer member 108 may receive heat (Q) from the storage compartments 21, 22, and 23 and transfer the heat to the first transparent substrate 101.

The second heat transfer member 109 may be farther from the storage compartments 21, 22, and 23 than the first heat transfer member 108, the transparent electrodes 102 and 104, and the transparent substrates 101 and 105. The second heat transfer member 109 may be disposed between the second transparent substrate 105 and the outside of the display 100. The second heat transfer member 109 may be in contact with the second transparent substrate 105. The second heat transfer member 109 may receive heat (Q) from the second transparent substrate 105 and release the heat to the outside of the display 100.

The display 100 may include a barrier wall 106. The barrier wall 106 may be disposed between the first transparent electrode 102 and the second transparent electrode 104. The barrier wall 106 may form a space 107 in which the changing layer 103 and an inert gas are located. The barrier wall 106 may be provided in plural numbers to support between the first transparent electrode 102 and the second transparent electrode 104. An inert gas may be located in the space 107 formed by the barrier wall 106. For example, the inert gas may include argon (Ar). Due to very low thermal conductivity of argon, the space 107 may have excellent insulation effect between the first transparent electrode 102 and the second transparent electrode 104. Therefore, introduction of heat outside the storage compartments 21, 22, and 23 into the storage compartments 21, 22, and 23 may be minimized/reduced. However, the disclosure is not limited thereto, and the inside of the space 107 may be in a vacuum state. For example, the barrier wall 106 may include urethane foam.

The changing layer 103 may be moved. For example, referring to FIG. 7, the changing layer 103 may be in contact with the second transparent electrode 104 based on application of the first voltage V1 thereto. Based on the contact between the changing layer 103 and the second transparent electrode 104, the first voltage V1 may be applied to the changing layer 103. Upon application of the first voltage V1 to the changing layer 103, the temperature of the changing layer 103 may increase and heat may be transferred from the changing layer 103 to the second transparent electrode 104 in contact therewith. Because the increased temperature T1 of the changing layer 103 may be higher than the temperature outside the storage compartments 21, 22, and 23 and the outside of the display 100, heat may be transferred from the changing layer 103 to the outside of the storage compartments 21, 22, and 23 and the outside of the display 100 through the second transparent electrode 104, the second transparent substrate 105, and the second heat transfer member 109. For example, based on application of the first voltage V1 to the changing layer 103, heat inside the display may be released to the outside of the storage compartments 21, 22, and 23. The changing layer 103 may return to an initial temperature T0 by releasing heat to the outside of the storage compartments 21, 22, and 23.

In addition, referring to FIG. 8, based on removal of the first voltage V1, the changing layer 103 may be brought into contact with the first transparent electrode 102. Based on contact between the changing layer 103 and the first transparent electrode 102, the first voltage V1 may be removed from the changing layer 103. When the first voltage V1 is removed from the changing layer 103, the temperature of the changing layer 103 may decrease and heat may be transferred to the changing layer 103 from the first transparent electrode 102 in contact therewith. Because the decreased temperature T2 of the changing layer 103 may be lower than the temperature inside the storage compartments 21, 22, and 23, heat may be transferred from the storage compartments 21, 22, and 23 to the changing layer 103 through the first heat transfer member 108, the first transparent substrate 101, and the first transparent electrode 102. For example, based on removal of the first voltage V1 from the changing layer 103, heat inside the storage compartments 21, 22, and 23 may be transferred to the changing layer 103. The decreased temperature T2 of the changing layer 103 may be lower than the initial temperature T0 of the changing layer 103.

By repeating application and removal of the first voltage V1 to and from the changing layer 103, heat inside the storage compartments 21, 22, and 23 may be transferred to the display 100 and heat of the display 100 may be transferred to the outside of the storage compartments 21, 22, and 23 and the outside of the display 100. Therefore, the refrigerator according to an embodiment may cool the storage compartments 21, 22, and 23 by switching On/Off of the voltage to the display 100.

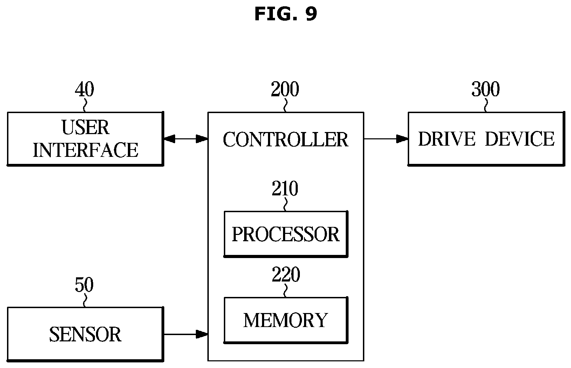

The changing layer 103 may be moved by the drive device 300. The drive device 300 may be controlled by a processor 210 (See FIG. 9).

FIG. 9 is a block diagram illustrating an example configuration of a refrigerator according to various embodiments.

Referring to FIG. 9, the refrigerator may further include the drive device 300. The drive device 300 may move the changing layer 103. The drive device 300 may move the changing layer 103 to be in contact with the first transparent electrode 102 or the second transparent electrode 104 based on application or removal of the first voltage V1 to or from the changing layer 103. For example, in response to the application of the first voltage V1 to the changing layer 103, the drive device 300 may move the changing layer 103 to be in contact with the second transparent electrode 104. In addition, for example, in response to the removal of the first voltage V1 from the changing layer 103, the drive device 300 may move the changing layer 103 to be in contact with the first transparent electrode 102.

After the drive device 300 moves the changing layer 103, the first voltage V1 may be applied to or removed from the changing layer 103.

The drive device 300 may include an actuator, a motor, and the like. However, the drive device 300 is not limited thereto as long as the drive device 300 moves the changing layer 103.

The refrigerator may include a user interface (e.g., including circuitry) 40. The user interface 40 may be provided at doors 31, 32, 33, and 34, the display 100, and/or the like. The user may manipulate the user interface 40 to apply the first voltage V1 or the second voltage V2 to the display 100. The user interface 40 may include both an input interface and an output interface. For example, the input interface may include a touch panel. For example, based in a user's touch on the touch panel, the second voltage V2 may be applied to the display 100 to which the first voltage V1 was applied. The user interface 40 may be formed by partially patterning the display 100. In addition, the user interface 40 may display a voltage applied to the display 100 while the first voltage V1 or the second voltage V2 is applied thereto.

The refrigerator may include at least one sensor 50. The sensor 50 may detect whether the user approaches the refrigerator. For example, the sensor 50 may detect whether the user approaches the doors 31, 32, 33, and 34 and/or the display 100 and transmit a value of the sensor 50 regarding the user's approach to a controller 200 and/or a processor 210.

For example, at least one sensor 50 may include a camera, an infrared sensor, and a proximity sensor. However, the type and location of the sensor 50 of the user are not limited thereto.

The refrigerator may include a controller 200. The controller 200 may include a hardware component such as a central processing unit (CPU), Micom, or a memory and a software component such as a control program. For example, the controller 200 may include at least one memory 220 to store algorithms to control the operation of components of the refrigerator and data in the form of programs, and at least one processor (e.g., including processing circuitry) 210 configured to perform the above-described operation and operation to be described below using the data stored in the at least one memory 220. The memory 220 and the processor 210 may be implemented as separate chips. The processor 210 may include 1 or 2 or more processor chips or 1 or 2 or more processing cores. The memory 220 may include 1 or 2 or more memory chips or 1 or 2 or more memory blocks. In addition, the memory 220 and the processor 210 may be implemented as a single chip. The chips of the controller 200 may be located in the displays 10. Further, the processor 210 may include various processing circuitry and/or multiple processors. For example, as used herein, including the claims, the term "processor" may include various processing circuitry, including at least one processor, wherein one or more of at least one processor, individually and/or collectively in a distributed manner, may be configured to perform various functions described herein. As used herein, when "a processor", "at least one processor", and "one or more processors" are described as being configured to perform numerous functions, these terms cover situations, for example and without limitation, in which one processor performs some of recited functions and another processor(s) performs other of recited functions, and also situations in which a single processor may perform all recited functions. Additionally, the at least one processor may include a combination of processors performing various of the recited /disclosed functions, e.g., in a distributed manner. At least one processor may execute program instructions to achieve or perform various functions.

The processor 210 may move the changing layer 103 by controlling the drive device 300. The processor 210 may move the changing layer 103 by controlling the drive device 300 in the heat-releasing state of the display 100. For example, based on application or removal of the first voltage V1 to or from the changing layer 103, the processor 210 may control the drive device 300 to move the changing layer 103 to be in contact with the first transparent electrode 102 or the second transparent electrode 104.

For example, in the heat-releasing state of the display 100, the processor 210 may control the drive device 300 to move the changing layer 103 to be in contact with the second transparent electrode 104 in response to application of the first voltage V1 to the changing layer 103. In addition, for example, in response to removal of the first voltage V1 from the changing layer 103, the processor 210 may control the drive device 300 to move the changing layer 103 to be in contact with the first transparent electrode 102.

Based on the value obtained from the sensor 50, the processor 210 may switch the state of the display 100 to the heat-releasing state or the transparent state. For example, in response to no approach of the user to the doors 31, 32, 33, and 34 and/or the display 100, the processor 210 may control the display 100 to operate in the heat-releasing state. Alternatively, in response to the user's approach to the doors 31, 32, 33, and 34 and/or the display 100, the processor 210 may control the display 100 to operate in the transparent state.

The heat-releasing state may include an opaque state. The opaque state may also be expressed as a cloudy state, a non-transmittance state, a high absorption state, and/or a high refractive-index difference state. The transparent state may be expressed as a clear state, a high transmittance state, a low absorption state, and/or a small refractive-index difference state. The heat-releasing state may also be expressed as a heat-releasing mode. The transparent state may also be expressed as a transparent mode.

In addition, the processor 210 may control the voltage applied to the changing layer 103 upon receiving a signal from at least one sensor 50. The processor 210 may apply the first voltage V1 or the second voltage V2 to the changing layer 103 based on the value obtained from the sensor 50.

For example, based on no approach of the user to the doors 31, 32, 33, and 34 and/or the display 100, the processor 210 may repeat application or removal of the first voltage V1 to or from the changing layer 103. By applying or removing the first voltage V1 to or from the changing layer 103, heat may be released to the outside of the storage compartments 21, 22, and 23 from the storage compartments 21, 22, and 23 through the display 100. The processor 210 may repeat On/Off of the first voltage V1 to the changing layer 103 while the display 100 is in the heat-releasing state.

Based on the user's approach to the doors 31, 32, 33, and 34 and/or the display 100, the processor 210 may continuously apply the second voltage V2 to the changing layer 103. Upon application of the second voltage V2 to the changing layer 103, the haze of the display 100 decreases to allow the user to see inside of the storage compartments 21, 22, and 23 without opening the doors 31, 32, 33, and 34. The processor 210 may continuously apply the second voltage V2 to the changing layer 103 while the display 100 is in the transparent state.

In addition, upon receiving an input signal from the user interface 40, the processor 210 may control the voltage applied to the changing layer 103. For example, based on a user's input, the processor 210 may cool the inside of the storage compartments 21, 22, and 23 by applying the first voltage V1 to the changing layer 103, or may allow the user to see the inside of the storage compartments 21, 22, and 23 without opening the door by decreasing the haze of the display 100 by applying the second voltage V2 to the changing layer 103.

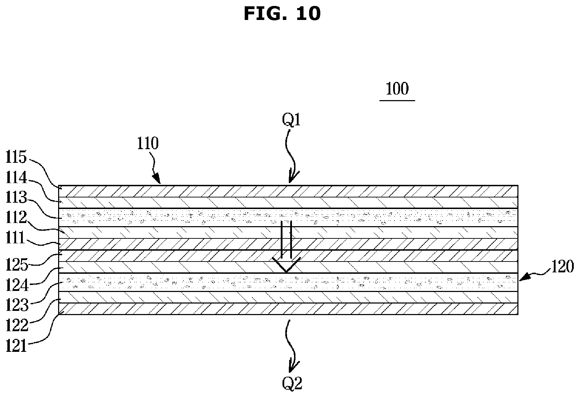

FIG. 10 is a cross-sectional view of a display in a refrigerator according to various embodiments.

Referring to FIG. 10, the display 100 may include a plurality of display layers 110 and 120. The plurality of display layers 110 and 120 may be stacked. The plurality of display layers 110 and 120 may be in contact with each other. The plurality of display layers 110 and 120 may include a first display layer 110 and a second display layer 120.

The first display layer 110 may include a first transparent substrate 111, a second transparent substrate 115, a first transparent electrode 112, a second transparent electrode 114, and a changing layer 113. The second display layer 120 may include a first transparent substrate 121, a second transparent substrate 125, a first transparent electrode 122, a second transparent electrode 124, and a changing layer 123. The first transparent substrates 111 and 121, the second transparent substrates 115 and 125, the first transparent electrodes 112 and 122, the second transparent electrodes 114 and 124, and the changing layers 113 and 123 of the first display layer 110 and the second display layer 120 may have structures and properties substantially corresponding to those of the first transparent substrate 101, the second transparent substrate 105, the first transparent electrode 102, the second transparent electrode 104, and the changing layer 103 as described in FIG. 3. Therefore, each of the changing layers 113 and 123 of the first display layer 110 and the second display layer 120 may include an electrocaloric material and a light-scattering material. In addition, each of the first display layer 110 and the second display layer 120 may further include a first heat transfer member 108 and a second heat transfer member 109.

The first display layer 110 and the second display layer 120 may be stacked and in contact with each other. For example, the first transparent substrate 111 of the first display layer 110 may be in contact with the second transparent substrate 125 of the second display layer 120.

The first display layer 110 may be disposed to be closer to the storage compartments 21, 22, and 23 than the second display layer 120. The first display layer 110 may receive heat Q1 from the storage compartments 21, 22, and 23 and transfer the heat Q1 to the second display layer 120. For example, based on application of the first voltage V1 lower than the preset voltage to the changing layer 113 of the first display layer 110, the first display layer 110 may transfer heat from the storage compartments 21, 22, and 23 to the second display layer 120.

The second display layer 120 may be disposed to be farther from the storage compartments 21, 22, and 23 than the first display layer 110. Upon receiving heat from the first display layer 110, the second display layer 120 may release heat to the outside of the storage compartments 21, 22, and 23. For example, based on application of the first voltage V1, smaller than the preset voltage, to the changing layer 123 of the second display layer 120, the second display layer 120 may transfer heat Q2 from the first display layer 110 to the outside of the main body 10.

For example, based on application of the electric field to the changing layer 123 of the second display layer 120, the temperature of the second display layer 120 may increase and heat may be transferred from the second display layer 120 to the outside of the main body 10 and the display 100. On the contrary, based on removal of the electric field from the changing layer 113 of the first display layer 110, the temperature of the first display layer 110 may decrease and heat may be transferred from the storage compartments 21, 22, and 23 to the first display layer 110.

Based on removal of the electric field from the changing layer 123 of the second display layer 120 and application of the electric field to the changing layer 113 of the first display layer 110, the temperature of the second display layer 120 may decrease and the temperature of the first display layer 110 may increase, so that heat may be transferred from the first display layer 110 to the second display layer 120.

Therefore, heat inside the storage compartments 21, 22, and 23 may be released to the outside of the storage compartments 21, 22, and 23 and the main body 10 along the first display layer 110 and the second display layer 120. In addition, these processes described above may be repeated at the first voltage V1 smaller than the preset voltage.

In other words, because heat may be transferred from the inside of the storage compartments 21, 22, and 23 to the outside of the storage compartments 21, 22, and 23 based on application of the first voltage V1 to the changing layers 113 and 123 in the refrigerator according to an embodiment, the inside of the storage compartments 21, 22, and 23 may be insulated or cooled.

In addition, because the plurality of display layers 110 and 120 including the first display layer 110 and the second display layer 120 are stacked, there may be a big difference between a low temperature and a high temperature of the display 100, the display 100 is highly effective in cooling, and electric power to operate an evaporator used for cooling the storage compartments 21, 22, and 23 may be reduced.

In addition, as light scattering by the light-scattering material 103b is reduced based on application of the second voltage V2 to the changing layers 113 and 123 in the refrigerator according to an embodiment, the haze of the changing layers 113 and 123 may decrease and the user may see the inside of the storage compartments 21, 22, and 23 through the display 100, thereby improving the convenience of the user.

The first display layer 110 may be a first window layer, and the second display layer 120 may be a second window layer.

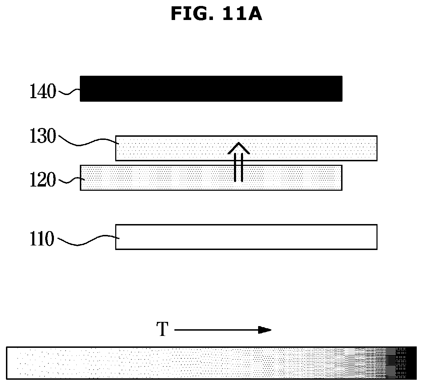

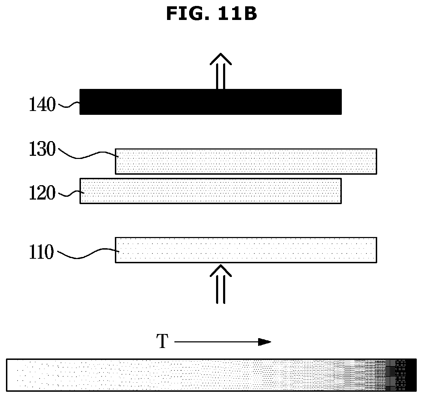

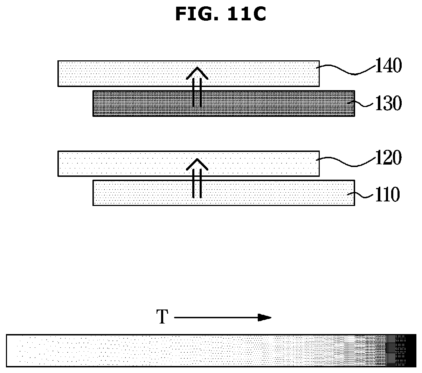

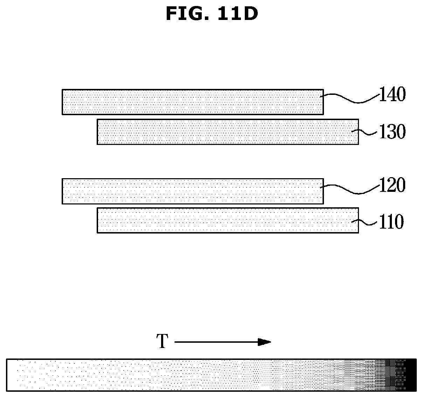

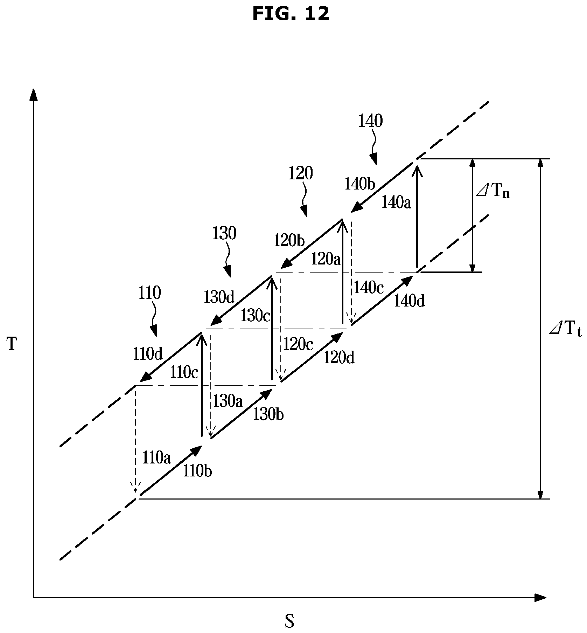

FIGS. 11A, 11B, 11C and 11D are diagrams illustrating a display in a refrigerator according to various embodiments. FIG. 12 is a graph regarding a display in a refrigerator according to various embodiments.

Referring to FIGS. 11A, 11B, 11C, 11D and 12, the display 100 may include a plurality of display layers 110, 120, 130, and 140. The plurality of display layers 110, 120, 130, and 140 may be stacked. The plurality of display layers 110, 120, 130, and 140 may be in contact with each other. The plurality of display layers 110, 120, 130, and 140 may include a first display layer 110, a second display layer 120, a third display layer 130, and a fourth display layer 140.

Each of the plurality of display layers 110, 120, 130, and 140 may include a first transparent substrate 101, a second transparent substrate 105, a first transparent electrode 102, a second transparent electrode 104, a first heat transfer member 108, a second heat transfer member 109, and a changing layer 103.

The first display layer 110 may be disposed to be closer to the storage compartments 21, 22, and 23 than the second display layer 120, the third display layer, and the fourth display layer 140 and farther from the outside of the storage compartments 21, 22, and 23 and the outside of the display 100.

The second display layer 120 may be disposed to be farther from the storage compartments 21, 22, and 23 than the first display layer 110 and closer to the storage compartments 21, 22, and 23 than the third display layer 130 and the fourth display layer 140.

The third display layer 130 may be disposed to be closer to the storage compartments 21, 22, and 23 than the first display layer 110 and the second display layer 120 and farther from the storage compartments 21, 22, and 23 than the fourth display layer 140.

The fourth display layer 140 may be disposed to be farther from the storage compartments 21, 22, and 23 than the first display layer 110, the second display layer, and the third display layer 130 and closer to the outside of the storage compartments 21, 22, and 23 and the outside of the display 100.

The plurality of display layers 110, 120, 130, and 140 may include the same electrocaloric material or different types of electrocaloric materials. According to the following processes, the plurality of display layers 110, 120, 130, and 140 may operate in different temperature ranges, respectively.

Referring to FIG. 11A, the second display layer 120 may be in contact with the third display layer 130, and the first voltage V1 may be applied to the second display layer 120 and the fourth display layer 140 and the voltage may be removed from the first display layer 110 and the third display layer 130. Therefore, the temperatures of the second display layer 120 and the fourth display layer 140 increase and the temperatures of the first display layer 110 and the third display layer 130 decrease, resulting in heat transfer from the second display layer 120 to the third display layer 130.

Referring to FIG. 11B, heat may be released from the fourth display layer 140 to the outside of the display 100 and the outside of the storage compartments 21, 22, and 23. In addition, heat may be transferred from the storage compartments 21, 22, and 23 to the first display layer 110. The first display layer 110 may absorb heat from the storage compartments 21, 22, and 23. The second display layer 120 and the third display layer 130 may be in thermal equilibrium.

Referring to FIG. 11C, the first display layer 110 may be in contact with the second display layer 120, and the third display layer 130 may be in contact with the fourth display layer 140. In addition, the first voltage V1 may be applied to the first display layer 110 and the third display layer 130, and the voltage may be removed from the second display layer 120 and the fourth display layer 140. Therefore, the temperatures of the first display layer 110 and the third display layer 130 increase and the temperatures of the second display layer 120 and the fourth display layer 140 decrease, so that heat may be transferred from the first display layer 110 to the second display layer 120 and heat may be transferred from the third display layer 130 to the fourth display layer 140.

Referring to FIG. 11D, by the heat transfer, the first display layer 110 and the second display layer 120 may be in thermal equilibrium, and the third display layer 130 and the fourth display layer 140 may be in thermal equilibrium. Thereafter, the process may return to that illustrated in (a) of FIG. 11.

Referring to FIG. 12, each of the plurality of display layers 110, 120, 130, and 140 may operate in different temperature ranges. In addition, the temperature ranges of the plurality of display layers 110, 120, 130, and 140 may partially overlap each other.

The temperature of the first display layer 110 may decrease by removing the voltage therefrom (110a). The first display layer 110 may absorb heat from the storage compartments 21, 22, and 23 (110b). The temperature of the first display layer 110 may increase by applying the voltage thereto (110c). The first display layer 110 may transfer heat to the second display layer 120 (110d).

The temperature of the second display layer 120 may increase by applying the voltage thereto (120a). The second display layer 120 may transfer heat to the third display layer 130 (120b). The temperature of the second display layer 120 may decrease by removing the voltage therefrom (120c). The second display layer 120 may receive heat from the first display layer 110 (120d).

The temperature of the third display layer 130 may decrease by removing the voltage therefrom (130a). The third display layer 130 may absorb heat from the second display layer 120 (130b). The temperature of the third display layer 130 may increase by applying the voltage thereto (130c). The third display layer 130 may transfer heat to the fourth display layer 140 (130d).

The temperature of the fourth display layer 140 may increase by applying the voltage thereto (140a). The fourth display layer 140 may release heat to the outside of the display 100 and the outside of the storage compartments 21, 22, and 23 (140b). The temperature of the fourth display layer 140 may decrease by removing the voltage therefrom (140c). The fourth display layer 140 may receive heat from the third display layer 130 (140d).

According to the above-described processes, the plurality of display layers 110, 120, 130, and 140 may transfer heat to each other while operating in different temperature ranges. Therefore, the refrigerator according to an embodiment may include the display 100 having a wider temperature range (ΔTt) than a temperature range (ΔTn) available by a single display layer. Because the temperature range (ΔTt) between the highest temperature and the lowest temperature of the display 100 including the plurality of display layers 110, 120, 130, and 140 is widened, the refrigerator may realize highly effective cooling using the display 100.

The first display layer 110 may be a first window layer, the second display layer 120 may be a second window layer, the third display layer 130 may be a third window layer, and the fourth display layer 140 may be a fourth window layer.

According to an aspect of the present disclosure, provided is a refrigerator including a display having a haze (e.g., opacity) adjustable to allow the inside of the storage compartment to visible or invisible with increased energy efficiency by cooling the storage compartment using a single display.

The effects of the present disclosure are not limited to the aforementioned effects, and other effects, which are not mentioned above, will be clearly understood by those skilled in the art from the disclosure, including the claims.

A refrigerator according to an example :embodiment may include storage compartments, doors provided to cover the storage compartments and configured to open and close, and a display provided on the doors and including an electrocaloric material and a light-scattering material, wherein the display is configured to release heat to the outside of the storage compartments from the storage compartments by a change in the electrocaloric material based on application of a first voltage less than a specified voltage to the display, and to reduce scattering of light incident on the display by a change in the light-scattering material based on application of a second voltage greater than the specified voltage to the display.

The display may include a display layer, wherein the display layer may further include: a first transparent substrate; a first transparent electrode disposed on the first transparent substrate; a second transparent electrode disposed on the first transparent electrode; a second transparent substrate disposed on the second transparent electrode; and a changing layer disposed between the first transparent electrode and the second transparent electrode and including the electrocaloric material and the light-scattering material, wherein the display, is configured in a heat-releasing state in which a temperature of the electrocaloric material increases to release heat to the outside of the storage compartment upon determination that a voltage applied to the changing layer is the first voltage, and is configured in a transparent state in which the light-scattering material is aligned to reduce scattering of light incident on the display upon determination that the voltage applied to the changing layer is the second voltage.

The display layer may include a plurality of display layers, wherein the plurality of display layers include: a first display layer; and a second display layer in contact with the first display layer and disposed to be farther from the storage compartment than the first display layer, wherein the display is configured, in the heat-releasing state, to transfer heat inside the first display layer to the second display layer based on application of the first voltage to the changing layer of the first display layer and removal of the voltage from the changing layer of the second display layer, and to transfer heat in the storage compartment to the first display layer from the storage compartment and transfer heat in the second display layer to the outside of the storage compartment and to the outside of the display based on removal of the voltage from the changing layer of the first display layer and application of the first voltage to the changing layer of the second display layer.

In the heat-releasing state of the display, heat may be released to the outside of the storage compartment from the changing layer by increasing the temperature of the electrocaloric material based on application of the first voltage to the changing layer, and by decreasing the temperature of the electrocaloric material based on removal of the first voltage from the changing layer, and the application and removal of the first voltage to and from the changing layer may be repeated in the heat-releasing state of the display.

The refrigerator may further include a drive device comprising an acutator configured to move the changing layer to be in contact with the first transparent electrode or the second transparent electrode.

The first transparent electrode may be closer to the storage compartment than the second transparent electrode, and the refrigerator may further include: at least one processor, comprising processing circuitry, individually and/or collectively, configured to: control the drive device to bring the changing layer into contact with the second transparent electrode based on application of the first voltage to the changing layer and configured to control the drive device to bring the changing layer into contact with the first transparent electrode based on removal of the first voltage from the changing layer, in the heat-releasing state of the display.

At least one processor, individually and/or collectively, may be configured to apply the second voltage to the changing layer in the transparent state of the display.

The refrigerator may further include at least one sensor configured to detect whether a user approaches the refrigerator, wherein at least one processor, individually and/or collectively, is configured to apply the first voltage or the second voltage to the changing layer in response to receiving information on a user's approach.

At least one processor, individually and/or collectively, may be configured to apply the second voltage to the changing layer to control the display to be in the transparent state based on the user's approach to the refrigerator.

The display layer may further include a barrier wall disposed between the first transparent electrode and the second transparent electrode to form a space in which the changing layer moves.

The display layer may further include an inert gas between the first transparent electrode and the second transparent electrode.

The second transparent substrate may be disposed to be farther from the storage compartment than the first transparent substrate, and the display may include: a first heat transfer member comprising a thermally conductive material disposed on one side of the first transparent substrate within a first specified distance to the storage compartment and configured to transfer heat from the storage compartment to the display layer; and a second heat transfer member comprising a thermally conductive material disposed on one side of the second transparent substrate at a second specified distance greater than the first specified from the storage compartment and configured to release heat to the outside of the storage compartment from the display layer.

The display layer may include a plurality of display layers, and the plurality of display layers may include a first display layer; a second display layer configured to receive heat from the first display layer and disposed to be farther from the storage compartment than the first display layer; a third display layer configured to receive heat from the second display layer and disposed to be farther from the storage compartment than the second display layer; and a fourth display layer configured to receive heat from the third display layer and disposed to be farther from the storage compartment than the third display layer, wherein the display layer is configured to release heat received from the storage compartment to the first display layer to the outside of the storage compartment through the second display layer, the third display layer, and the fourth display layer.

In the heat-releasing state of the display, based on application of the first voltage to the second display layer and the fourth display layer and removal of the voltage from the first display layer and the third display layer, the display is configured to transfer heat from the inside of the storage compartment to the first display layer, from the second display layer to the third display layer, and from the fourth display layer to the outside of the storage compartment.

The refrigerator according to an example embodiment may include: a main body; doors pivotally coupled to the main body; and a window provided on the doors and including a first window layer and a second window layer farther from the inside of the main body than the first window layer, wherein the window is configured to transfer heat inside the first window layer to the second window layer based on application of a voltage to the first window layer and removal of the voltage from the second window layer and configured to transfer heat inside the main body to the first window layer and heat inside the second window layer to the outside of the main body and the outside of the window based on removal of the voltage from the first window layer and application of the voltage to the second window layer.

Each of the first window layer and the second window layer may include an electrocaloric material, the temperature of the electrocaloric material may increase based on application of the voltage to the first window layer and the second window layer, and the temperature of the electrocaloric material may decrease based on removal of the voltage from the first window layer and the second window layer, wherein heat is released to the outside of the main body from the first window layer and the second window layer, and the application and removal of the voltage to and from the first window layer and the second window layer may be repeated.

The window may include: a third window layer configured to receive heat from the second window layer and disposed to be farther from the inside of the main body than the second window layer; and a fourth window layer configured to receive heat from the third window layer and disposed to be farther from the inside of the main body than the third window layer, wherein heat transferred from the inside of the main body to the first window layer may be released to the outside of the main body through the second window layer, the third window layer, and the fourth window layer.

Each of the first window layer, the second window layer, the third window layer, and the fourth window layer may further include: a first transparent substrate; a first transparent electrode disposed on the first transparent substrate; a second transparent electrode disposed on the first transparent electrode; a second transparent substrate disposed on the second transparent electrode; and a changing layer disposed between the first transparent electrode and the second transparent electrode and provided with an electrocaloric material and a light-scattering material, where, in a heat-releasing state, in which the temperature of the electrocaloric material increases, the display may be configured to release heat to the outside of the main body upon determination that a voltage applied to the changing layer is the first voltage less than the specified voltage and in a transparent state in which the light-scattering material is aligned the display is configured to reduce scattering of light incident on the display upon determination that the voltage applied to the changing layer is the second voltage greater than the preset voltage.

The refrigerator according to an example embodiment includes: a main body, doors pivotally coupled to the main body, and a window provided on the doors and including a light-scattering material, wherein the light-scattering material is configured to be aligned by a voltage applied to the light-scattering material to reduce scattering of light incident on the window and decrease a haze of the window.

The window may further include: a first transparent substrate; a first transparent electrode disposed on the first transparent substrate; a second transparent electrode disposed on the first transparent electrode; a second transparent substrate disposed on the second transparent electrode; and a changing layer disposed between the first transparent electrode and the second transparent electrode and including a light-scattering material and an electrocaloric material, where a display may have a heat-releasing state in which the temperature of the electrocaloric material increases to release heat to the outside of the main body upon determination that a voltage applied to the changing layer is the first voltage smaller than the present voltage and a transparent state in which the light-scattering material is aligned to reduce scattering of light incident on the display upon determination that the voltage applied to the changing layer is the second voltage greater than the preset voltage.

In the heat-releasing state of the display, the display may be configured to release heat to the outside of the main body from the changing layer by increasing the temperature of the electrocaloric material based on application of the first voltage to the changing layer, and by decreasing the temperature of the electrocaloric material based on removal of the first voltage from the changing layer, and the application and removal of the first voltage to and from the changing layer may be repeated in the heat-releasing state of the display.

The refrigerator may further include at least one processor, comprising processing circuitry, individually and/or collectively, configured to apply the first voltage to the changing layer in the heat-releasing state of the display and configured to apply the second voltage to the changing layer in the transparent state of the display.

Although the various example embodiments of the present disclosure have been provided for illustrative purposes, the scope of the present disclosure is limited thereto. The various example embodiments that may be modified and altered by those skilled in the art without departing from the principles and spirit of the present disclosure, including the appended claims, and their equivalents. It will also be understood that any of the embodiment(s) described herein may be used in conjunction with any other embodiment(s) described herein.

## Claims

1. A refrigerator comprising:
a storage compartment;
a door provided on the storage compartment and configured to open and close; and
a display provided on the door and comprising an electrocaloric material and a light-scattering material,
wherein the display is configured to release heat from the storage compartment to the outside of the storage compartment by a change in the electrocaloric material based on application of a first voltage less than a specified voltage to the display, and configured to reduce scattering of light incident on the display by a change in the light-scattering material based on application of a second voltage greater than the specified voltage to the display.

2. The refrigerator according to claim 1, wherein the display comprises a display layer,
wherein the display layer comprises:
a first transparent substrate;
a first transparent electrode disposed on the first transparent substrate;
a second transparent electrode disposed on the first transparent electrode;
a second transparent substrate disposed on the second transparent electrode; and
a changing layer disposed between the first transparent electrode and the second transparent electrode and comprising the electrocaloric material and the light-scattering material,
wherein the display, in a heat-releasing state in which a temperature of the electrocaloric material increases, is configured to release heat to the outside of the storage compartment upon determination that a voltage applied to the changing layer is the first voltage, and in a transparent state in which the light-scattering material is aligned, is configured to reduce scattering of light incident on the display upon determination that the voltage applied to the changing layer is the second voltage.

3. The refrigerator according to claim 2, wherein the display layer comprises a plurality of display layers,
wherein the plurality of display layers comprise:
a first display layer; and
a second display layer in contact with the first display layer and disposed to be farther from the storage compartment than the first display layer,
wherein the display is configured, in the heat-releasing state,
to transfer heat inside the first display layer to the second display layer based on application of the first voltage to the changing layer of the first display layer and removal of the voltage from the changing layer of the second display layer, and
to transfer heat in the storage compartment to the first display layer from the storage compartment and transfer heat in the second display layer to the outside of the storage compartment and to the outside of the display based on removal of the voltage from the changing layer of the first display layer and application of the first voltage to the changing layer of the second display layer.

4. The refrigerator according to claim 2, wherein in the heat-releasing state of the display, the display is configured to release heat from the changing layer to the outside of the storage compartment by increasing the temperature of the electrocaloric material based on application of the first voltage to the changing layer, and by decreasing the temperature of the electrocaloric material based on removal of the first voltage from the changing layer, and
the application and removal of the first voltage to and from the changing layer are repeated in the heat-releasing state of the display.

5. The refrigerator according to claim 4, further comprising a drive device comprising an actuator configured to move the changing layer to be in contact with the first transparent electrode or the second transparent electrode.

6. The refrigerator according to claim 5, wherein the first transparent electrode is closer to the storage compartment than the second transparent electrode, and
the refrigerator further comprises at least one processor, comprising processing circuitry, individually and/or collectively, configured to: control the drive device to bring the changing layer into contact with the second transparent electrode based on application of the first voltage to the changing layer; and control the drive device to bring the changing layer into contact with the first transparent electrode based on removal of the first voltage from the changing layer, in the heat-releasing state of the display.

7. The refrigerator according to claim 6, wherein at least one processor, individually and/or collectively, is configured to apply the second voltage to the changing layer in the transparent state of the display.

8. The refrigerator according to claim 5, further comprising at least one sensor configured to detect whether a user approaches the refrigerator,
wherein at least one processor, individually and/or collectively is configured to apply the first voltage or the second voltage to the changing layer in response to receiving information on a user's approach from the sensor.

9. The refrigerator according to claim 8, wherein at least one processor, individually and/or collectively, is configured to apply the second voltage to the changing layer to control the display to be in the transparent state based on the user's approach to the refrigerator.

10. The refrigerator according to claim 5, wherein the second transparent substrate is disposed to be farther from the storage compartment than the first transparent substrate,
wherein the display layer comprises:
a barrier wall disposed between the first transparent electrode and the second transparent electrode to form a space where the changing layer is movable;
an inert gas provided between the first transparent electrode and the second transparent electrode;
a first heat transfer member comprising a thermally conductive material disposed on one side of the first transparent substrate within a first specified distance to the storage compartment and configured to transfer heat from the storage compartment to the display layer; and
a second heat transfer member comprising a thermally conductive material disposed on one side of the second transparent substrate within a second specified distance greater than the first specified distance from the storage compartment and configured to release heat from the display layer to the outside of the storage compartment.

11. The refrigerator according to claim 2, wherein the display layer comprises a plurality of display layers,
wherein the plurality of display layers comprise:
a first display layer;
a second display layer configured to receive heat from the first display layer and disposed to be farther from the storage compartment than the first display layer;
a third display layer configured to receive heat from the second display layer and disposed to be farther from the storage compartment than the second display layer; and
a fourth display layer configured to receive heat from the third display layer and disposed to be farther from the storage compartment than the third display layer,
wherein the display is configured to release heat received from the storage compartment to the first display layer to the outside of the storage compartment through the second display layer, the third display layer, and the fourth display layer.

12. The refrigerator according to claim 11, wherein in the heat-releasing state of the display, the display is configured to:
based on application of the first voltage to the second display layer and the fourth display layer and removal of a voltage from the first display layer and the third display layer,
transfer heat from the inside of the storage compartment to the first display layer,
transfer heat from the second display layer to the third display layer, and
release heat from the fourth display layer to the outside of the storage compartment.
